# EUROPEAN PATENT APPLICATION

(11) **EP 4 637 019 A1**
(43) Date of publication of application: **22.10.2025**
(21) Application number: 24275040.4
(22) Date of filing: 19.04.2024
(51) Int. Cl.: H02N 2/18, H10N 30/30, F42C 11/00

(54) **ENERGY HARVESTING SYSTEM, STRUCTURE, PROJECTILE, AND MUNITION**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

An energy harvesting system (50, 60) comprises a transducer (100) arranged to provide an output signal in response to deformation of the transducer (100) by an applied force to harvest energy from the applied force and a structure (200, 300) in mechanical communication with the transducer (100), deformation of the structure (200, 300) being arranged to cause deformation of the transducer (100). The structure (200, 300) comprises: a first portion (210, 310); a second portion (220, 320) in mechanical communication with the transducer (100); and one or more third portions (230, 330) connecting the first portion (210, 310) and second portion (220, 320), wherein the one or more third portions (230, 330) comprise one or more curved arms. Also provided is a structure (200, 300) for use in the energy harvesting system (50, 60), a projectile (2000) and a munition (3000).

## Description

### FIELD

The present invention relates to an energy harvesting system, in particular to an energy harvesting system comprising a transducer and a structure in mechanical communication with the transducer. The present invention further relates to a structure, projectile, and munition.

### BACKGROUND

Energy harvesting refers to the derivation of energy from external sources. For example, energy harvesting may mean deriving an electrical output from a mechanical input. A transducer is a device that is often used in energy harvesting systems, because it can convert energy from one form to another (transduction). Clearly, it is desirable to generate as much energy as possible from a given input to increase power generation or detection sensitivities. Hence, there is a need for an energy harvesting system that facilitates efficient energy harvesting.

### SUMMARY

According to a first aspect of the present invention, there is provided an energy harvesting system, comprising: a transducer arranged to provide an output signal in response to deformation of the transducer by an applied force to harvest energy from the applied force; a structure in mechanical communication with the transducer, deformation of the structure being arranged to cause deformation of the transducer, wherein the structure comprises: a first portion arranged to provide a contacting surface; a second portion in mechanical communication with the transducer; one or more third portions connecting the first portion and second portion, wherein the one or more third portions comprise at least a region of varying thickness.

The at least a region of varying thickness may be at least a region of tapering thickness.

The structure may have the form of a cymbal.

The tapering thickness may be in a radial direction away from the centre of the cymbal.

A gradient of the surface of the one or more third portions may reduce in a direction from the first portion to the second portion.

In an example, the system may comprise one or more apertures provided through the structure and/or slots provided at an edge of the structure.

The apertures provided through the structure may be symmetrically provided.

The structure and/or transducer may have an annular cross-section.

The transducer may be piezoelectric or magnetostrictive.

The one or more third portions may comprise one or more curved arms.

A housing may be provided around the transducer and structure, the housing configured to inhibit horizontal deflection of the structure during deformation of the structure.

The output signal may be used for powering an external component and/or detecting a change in state in the energy harvesting system.

According to a second aspect, there is provided a structure for use in an energy harvesting system, the energy harvesting system comprising a transducer arranged to provide an output signal in response to deformation of the transducer by an applied force to harvest energy from the applied force, the structure being in mechanical communication with the transducer, deformation of the structure being arranged to cause deformation of the transducer, wherein the structure comprises: a first portion arranged to provide a contacting surface; a second portion in mechanical communication with the transducer; one or more third portions connecting the first portion and second portion, wherein the one or more third portions comprise at least a region of varying thickness.

According to a third aspect, there is provided a projectile comprising the system of the first aspect or the structure of the second aspect.

According to a fourth aspect, there is provided a munition comprising the system of the first aspect or the structure of the second aspect.

According to a fifth aspect, there is provided an energy harvesting system, comprising: a transducer arranged to provide an output signal in response to deformation of the transducer by an applied force to harvest energy from the applied force; a structure in mechanical communication with the transducer, deformation of the structure being arranged to cause deformation of the transducer, wherein the structure comprises: a first portion; a second portion in mechanical communication with the transducer; one or more third portions connecting the first portion and second portion, wherein the one or more third portions comprise one or more curved arms.

The first portion may be centrally located in the structure, and the second portion may be provided around the first portion.

The first portion may be a rotatable member. The rotatable member may be, or may be in the form of, a shaft or hub.

The first portion may be rotatable relative to the second portion.

The structure may comprise three curved arms.

The one or more curved arms may each have between about 0.05 revolutions and 2 revolutions, preferably between about 1 revolution and 2 revolution, most preferably 2 revolutions. The number of revolutions may vary based on whether a force is applied to the structure. The number may vary based on rotational velocity, mass and energy available. In examples, the number of revolutions may be greater than, or less than, 2.

The one or more third portions may be symmetrically provided in the structure.

The one or more third portions may comprise at least a region of varying thickness.

The one or more third portions may comprise at least a region of tapering thickness.

A gradient of the surface of the one or more third portions may reduce in a direction from the first portion to the second portion.

The transducer may be piezoelectric or magnetostrictive.

A housing may be provided around the transducer and structure, the housing configured to inhibit horizontal deflection of the structure during deformation of the structure.

The output signal may be used for powering an external component and/or detecting a change in state in the energy harvesting system.

According to a sixth aspect, there is provided a structure for use in an energy harvesting system, the energy harvesting system comprising a transducer arranged to provide an output signal in response to deformation of the transducer by an applied force to harvest energy from the applied force, the structure being in mechanical communication with the transducer, deformation of the structure being arranged to cause deformation of the transducer, wherein the structure comprises: a first portion; a second portion in mechanical communication with the transducer; one or more third portions connecting the first portion and second portion, wherein the one or more third portions comprise one or more curved arms.

According to a seventh aspect, there is provided a projectile comprising the system of the fifth aspect or the structure of the sixth aspect.

According to an eighth aspect, there is provided a munition comprising the system of the fifth aspect or the structure of the sixth aspect.

Features of any of the first to eighth aspects may be combined as desired or as appropriate.

### BRIEF DESCRIPTION OF THE FIGURES

Embodiments of the invention will now be described by way of example only with reference to the figures, in which:
Figure 1 shows a perspective view of an energy harvesting system;
Figure 2 shows a side view of an energy harvesting system;
Figure 3 shows a part-cutaway view of an energy harvesting system in contact with a body;
Figure 4 shows a perspective view of a structure;
Figure 5 shows a perspective view of an energy harvesting system;
Figure 6 shows a perspective view of an energy harvesting system;
Figures 7a to 7d each show a plan view of a structure; and
Figure 8 schematically depicts a projectile or munition comprising a system including a transducer and a structure.

### DETAILED DESCRIPTION

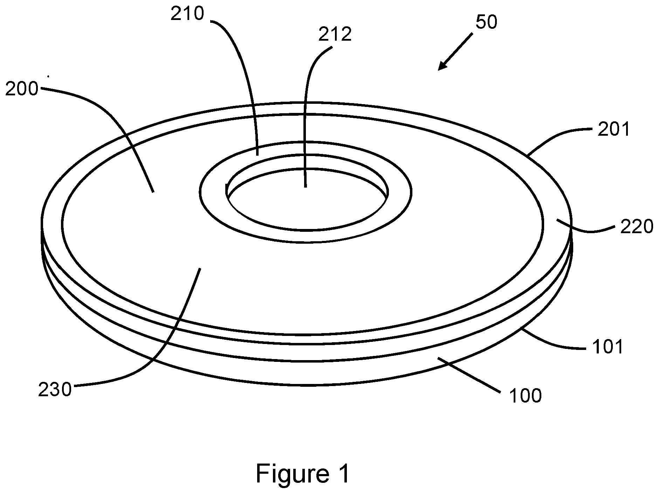

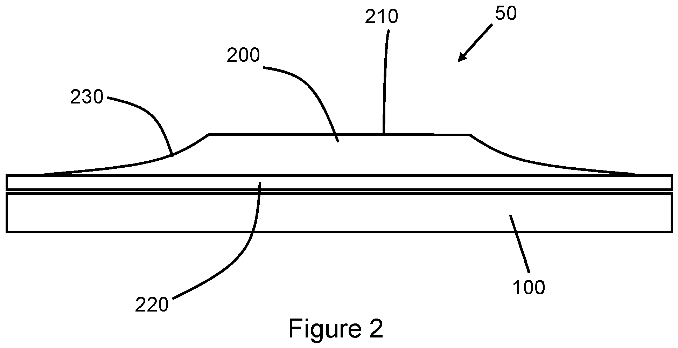

In overview, an energy harvesting system 50 comprises a transducer 100 and a structure 200. The system 50 comprising the transducer 100 and the structure 200 shown in Figure 1 and 2. The transducer 100 and the structure 200 are shown together and, as explained below, as part of the energy harvesting system 50 they are typically in mechanical communication, e.g., in physical contact. The structure 200 may be integrated in the energy harvesting system or may be a separate part of the energy harvesting system configured to be exchanged and replaced. An energy harvesting system 60 may comprise a transducer with an embodiment of a structure 300.

The transducer 100 is arranged to provide an output signal in response to deformation of the transducer 100 by an applied force. This harvests energy from the applied force. The structure 200, 300 is in mechanical communication with the transducer 100. Deformation of the structure 200, 300 is arranged to cause deformation of the transducer 100.

Referring to Figure 1, the energy harvesting system 50 is shown. The energy harvesting system 50 comprises the transducer 100 and a structure 200.

The perimeter of the transducer 100 is circular. The transducer 100 may be annular in shape. In examples, the transducer is circular, disc-shaped or another suitable shape.

The transducer 100 is arranged to provide an output signal which could be the generation of voltage. The output signal e.g. generation of voltage, is outputted in response to deformation of the transducer 100 by an applied force resulting from a compressive force applied to the transducer 100. This advantageously means that energy is harvested from the applied, compressive force.

The transducer 100 typically comprises piezoelectric material, preferably perovskite, or a magnetostrictive material. Advantageously, these materials allow generation of energy in response to an applied force. Piezoelectric materials may be preferred, as they generate power without the need for, e.g., a take-off coil arrangement or similar. Perovskite materials or structures may find particular use in the embodiments discussed here, because such materials are more efficient at energy generation under shear force compared with compressive force.

There will likely downward compression of the structure 100 on the transducer 100 as result of the applied force. Energy is harvested from the applied force on the transducer 100, for example by deformation of the piezoelectric material, or magnetostrictive material, in the transducer 100. In use, compression of the transducer from an applied force causes deformation of the transducer 100. In response to the deformation, an output signal is generated, such as an output voltage, due to, for example, the piezoelectric material in the transducer 100. For an annular transducer 100, having an inner hole or space might prevent the introduction of odd or unexpected forces, or buckling, at the central region of the transducer 100. The transducer 100 may be disc-shaped or circular, or have any other suitable shape that can suitably receive an applied force and deform under downward compression.

The structure 200 comprises a first portion 210 arranged to provide a contacting surface, a second portion 220 in communication with the transducer 100 and one or more third portions 230. The one or more third portions 300 comprise at least a region of varying thickness.

The structure 200 is a bridge structure that advantageously amplifies the force applied to the transducer 100. The structure 200 may have the form of a cymbal. In this context, a cymbal structure is a metal circular bridge structure that sits on the face of a transducer, for example a piezoceramic disc, and advantageously creates force amplification.

The structure 200 is in mechanical communication with the transducer 100. Being in mechanical communication typically means that the structure 200 contacts the transducer 100. For example, the structure 200 may overlay the transducer 100. This contact may be mediated by a material in between the transducer 100 and the structure 200. As a consequence of the mechanical communication between the structure 200 and the transducer 100, deformation of the structure 200 causes deformation of the transducer 100. The structure 200 improves the compression force conversion to shear force for improved mechanical to electrical energy generation. The system 50 may configured to be provided on a platform and comprises a layer of damping material provided between the platform and the transducer.

As shown in Figure 2, the structure 200 sits on a face of the transducer 100 and extends across the transducer 100.

The perimeter 201 of the structure 200 circular. The perimeter 201 of the structure 200 tracks the perimeter of the transducer 100 such that the structure 200 overlies the transducer 100. In other words, the structure 200 and transducer 100 may be correspondingly shaped. The structure 200 may be disc shaped. Advantageously, the absence of corners engenders predictability of the direction of the shear force. In plan view, the structure 200 and/or transducer 100 may be annular. In other words, the structure 200 and/or transducer 100 may have a circular outline with an aperture in its or their centre. Advantageously, in addition the absence of corners engendering predictability of the direction of the shear force, the flexibility of the structure 200 and/or transducer 100 enables the structure 200 and/or transducer 100 to uniformly expand under compressive force, which may help avoid damage. Advantageously, the corresponding shapes of the structure 200 and the transducer 100 allow for an improved transfer of compressive force. This means that a greater amount of energy may be harvested.

The structure 200 comprises a first portion 210, a second portion 220 and a third portion 230.

The first portion 210 provides a contacting surface to receive an applied force from a mass or body. The first portion 210 is centrally located on the structure 200.

The first portion 210 comprises a cavity 212 in its central axis. Providing the cavity 212 may advantageously remove excess material to reduce internal stress. This may, in turn, increase deformation of the structure 200 to improve the transmission of force to the transducer 100. In examples, the cavity 212 may be omitted from the first portion. In examples, a cavity 212 may be provided that is not centrally located. The first portion 210 allows for a contacting surface of the structure which can receive a compressive force on the structure 200.

The second portion 220 is provided around the first portion 210. The second portion 220 is annular. The second portion 220 is provided adjacent to the perimeter 201 of the structure 200.

In the energy harvesting system 50, the second portion 220 is in mechanical communication with the transducer 100. The second portion 220 contacts the transducer 100 in the area adjacent to the perimeter of the transducer 101. Advantageously, the mechanical communication between the second portion 220 and the transducer 100 allows for a compressive force on the structure 200 to cause deformation of the transducer 100. In turn, this harvests energy from the applied force to provide an output signal.

The third portion 230 is annular. The third portion 230 connects the first portion 210 and the second portion 220 of the structure 200. The third portion 230 extends from the first portion 210 to the second portion 220. The third portion 230 surrounds the first portion 210 and is surrounded by the second portion 220. As such, the cross section of the structure 200 is annular.

The third portion 230 of the structure 200 has a region of varying thickness. In examples, the region of varying thickness may be a region of tapering thickness. In examples, the region of varying thickness may comprise a step change in at least part of the third portion 230. In examples, the third portion 230 may comprise at least a first recess or at least one divot. The recess or divot may provide for a region of varying thickness in the third portion 230. The third portion 230 may comprise a recessed channel that extends radial from or circumferentially around the first portion 210 to provide a region of varying thickness in the third portion 230. Advantageously, a region of varying thickness in the third portion 230 improves the flexibility of the structure 200. In turn, the transmission of force to the transducer 100 is improved, thereby improving energy harvesting in the system 50.

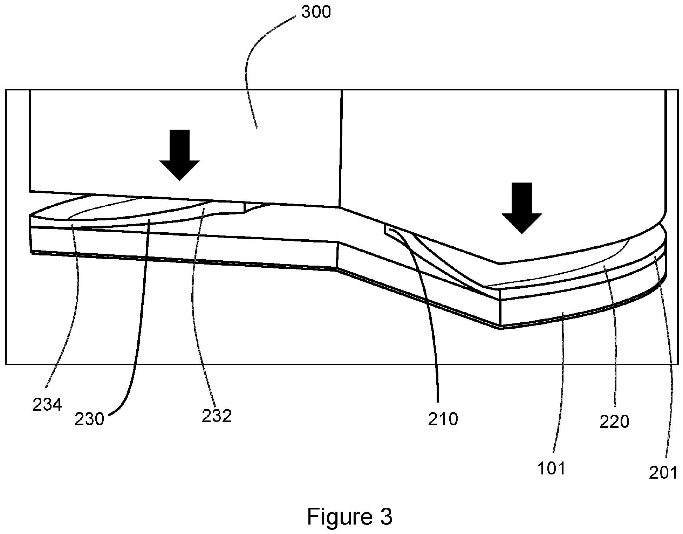

As shown Figure 3, the third portion 230 is thicker adjacent the first portion 210, The third portion 230 is thinner toward, in the region of, or proximal to, the second portion 220. In other words, the thickness of the third portion 230 reduces in the radial direction, i.e., along a radial axis, towards the second portion 220.

In an example, the third portion 230 tapers in thickness from the first portion 210 to the second portion 220. In other words, the third portion tapers in the radial direction away from the centre of the structure 200. Advantageously, this means that the structure 200 is more flexible. The removal of material in the thickness of the structure 200 has the advantageous effect that when a force is applied to the structure to cause deformation thereof, stress forces are not stored in the inner circumference of the structure 200, i.e. proximal to the first portion 210, and are instead more readily transmitted along the second portion 220 thereby to facilitate harvesting of the energy from the applied force at the transducer. Advantageously, having a region of the third portion 230 that is tapered is simple to construct while maintaining structure soundenss of the structure 200 under a compressive force. Improved flexibility provided by the tapered region of the third portion 230 means that the structure 200 deforms more, or more readily, under an applied compressive force. In turn, this transfers a greater force to the transducer 100. In response to the greater force, the transducer has greater deformation, leading to a greater and more efficient energy harvesting in the system 50.

Referring to Figure 2, a side view of the energy harvesting system 50 is shown. The structure 200 overlies the transducer 100. The second portion 220 of the structure 200 is in mechanical communication with the transducer 100 around the circumference 101 of the transducer 100.

The structure 200 is substantially frustoconical in shape. The second portion 220 has a greater circumference than the first portion 210. The third portion 230 connects the first portion 210 and the second portion. Advantageously, the shape of the structure 200 redirects the applied force in a circumferential direction. This may maximise energy transferred to the transducer 100. Increased force being transferred to the second portion 220, which is in communication with the transducer 100 in the system 50, increases force applied to the transducer. The shape of the structure 200 means that stress from an applied force is not confined to the centre of the structure 200 and instead is spread across the whole structure 200 in the radial direction. This means that the energy transfer by the structure 200 is improved, in turn improving energy output produced by the transducer.

The third portion 230 extends from the first portion 210 with a varying gradient. The gradient of the third portion 230 reduces in the direction from the first portion 210 to the second portion 220. The gradient of the third portion 230 is greatest adjacent to the first portion 210. In other words, the gradient of the third portion 230 reduces in the radial direction, i.e., along a radial axis, from the first portion 210 towards the second portion 220. In other words, the gradient, or slope, of the surface (e.g., an upper surface) of the third portion 230 reduces in an outward radial direction. Advantageously, this optimises the shape of the structure 200 to receive an applied force and transfer energy to the transducer. The reducing gradient of the third portion 230 improve flexibility of the structure 200 and allow for the applied compressive force received at the first portion 210 to be more evenly distributed across the whole of the structure. In particular, deformation of the structure 200 may be improved so that the force applied to the transducer 100 is improved, thereby improving energy harvesting by the transducer 100.

Referring to Figure 3, a part-cutaway view of the energy harvesting system 50 is shown with a body 300.

The body 300 is in contact with the contacting surface provided by the first portion 210 of the structure 200. The third portion 230 of the structure 200 is in contact with the transducer 100 at their respective perimeters, 201, 101.

The third portion 230 of the structure 200 has a region of tapering thickness. The thicker part 232 of the third portion 230 is located adjacent the first portion 210. The thinner part 234 of the third portion 230 is located adjacent the second portion 220. As such, the thickness of the third portion 230 reduces in the radial direction from the thicker part 232 to the thinner part 230. The thickness tapers along a radial axis, from the first portion 210 towards the second portion 220.

In use, the body 300 provides an applied force on the energy harvesting system 50 in the direction shown by the arrows in Figure 3. The force applied by the body 300 deforms the transducer 100 in response to the force applied on the transducer 100 by the structure 200. The body may be a component mounted on the structure. The structure may operate to harvest vibrations of the body. For example, the body maybe a part or component of a vibration generation body.

Advantageously, the varying thickness of the third portion 230 of the structure 200 provides for the removal of excess material. This reduces internal stress in the structure 200 to increase deformation of the structure 200. In turn, the force transmission to the transducer 100 to convert to electrical energy may be significantly improved.

In examples, the gradient of the third portion 230 may be constant between the first portion 210 and the second portion 220. In examples, only a portion of the thickness of the third portion 230 varies. In examples, the third portion 230 may comprise a recess, a channel or a divot to provide a region of varying thickness.

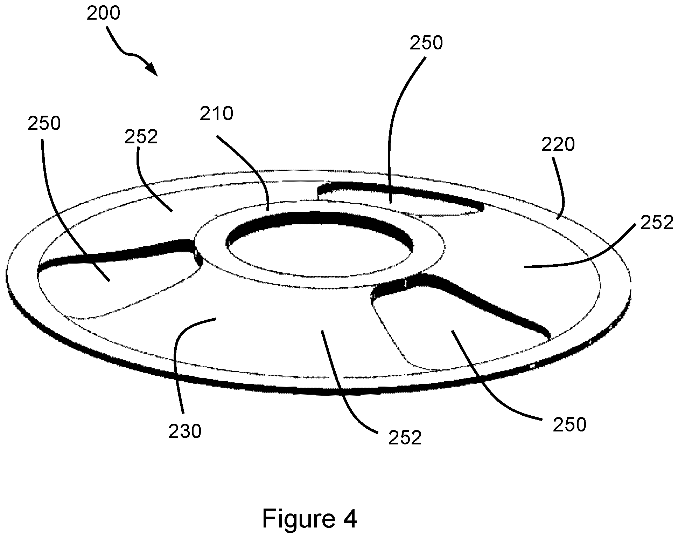

Referring to Figure 4, an embodiment of the structure 200 is shown. The structure 200 has a first portion 210 and a second portion 230 as already described. The third portion 230 has a reducing gradient and a varying thickness in the radial direction from the first portion 210 to the second portion 220.

The third portion 230 comprises apertures 250. In the embodiment shown in Figure 4, the third portion 230 comprises three apertures. The apertures 250 are evenly spaced around the circumference of the third portion 250. Each aperture 250 is provided through the entire thickness of the third portion 250. Advantageously, removing material from the structure 200 does not compromise the strength of the structure 200 but may make it more flexible to transfer energy to the transducer 100.

The apertures 250 each extend across the full radial width of the third portion 230. That is, the apertures 250 are provided as cut-outs in the third portion 230 that extend radially between the first portion 210 and the second portion 220. The apertures 250 are flared at their end proximate the third second portion. Advantageously, this shape of aperture 250 may improve the distribution of applied force on the structure 200. In embodiments, the apertures may not extend across the full radial width of the third portion 230 such that a part of the third portion surrounds the apertures 250.

The regions of the third portion 230 that extend between the apertures 250 may be described as arms 252. The arms 250 are the regions of the third portion 250 that extend between and connect the first portion 210 to the second portion of the structure 220.

In embodiments, more or less than three apertures 250 may be provided. In providing a different number of apertures 250, the number of arms 252 provided is equal to the number of apertures 250.

In embodiments, the apertures may be symmetrically provided. That is, the apertures are provided around the circumference of the third portion 230 such that they are symmetrical about an axis passing through the centre of the structure 200. Advantageously, symmetrically provided apertures may result in a more even distribution of the applied force to exert a greater force on the transducer 100 from the structure 200. Symmetry may also provides a balanced structure 200 that positively affects energy output. The structure 200 being more balanced may provide for a greater distribution of force and/or deformation of the structure 200. As such, the transducer 100 will have greater deformation and will harvest more energy in the energy harvesting system 50.

In use, a compressive force is applied to the structure 200. This results in downward compression of the structure 200. The structure 200 is deformed and amplifies the compressive force. The transducer 100 receives the amplified compressive force and deforms. In response to deformation of the structure, the transducer deforms. In response to the deformation, the transducer 100 generates an output signal. The energy harvesting system 50 optimises compression force and transfer of force to the transducer such that the output signal is increased and/or improved.

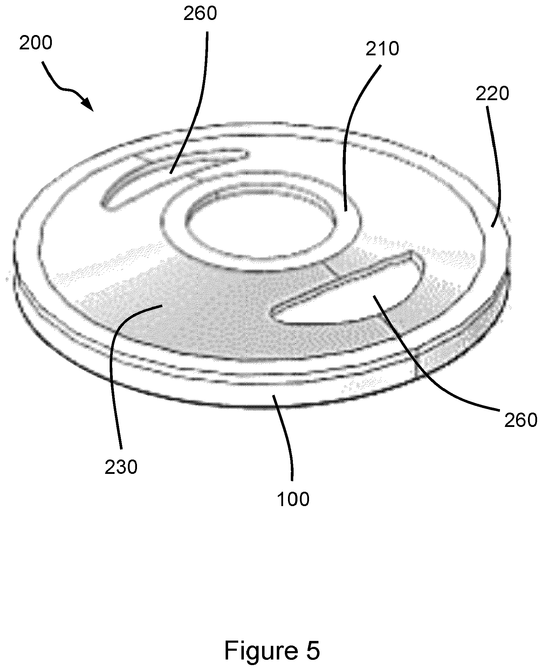

Referring to Figure 5, an embodiment of a structure 200 with a transducer 100 is shown. Two symmetrically spaced apertures 260 are provided in the third portion 230 of a structure 200. The structure 200 is otherwise identical to the structures previously described. The apertures 260 are provided on opposing sides of the first portion 210 in the second portion. The apertures 260 extend through the full depth of the third portion 210. The apertures 260 are semi-circular in shape. The apertures 260 each have a straight edge closest to the first portion 210 of the structure and a curved edge proximate the second portion 220. In embodiments, apertures of different suitable shapes may be provided.

In embodiments, the apertures 250 may be replaced by slots that are provided at the peripheral edge of the structure 200. The slots may extend from the perimeter 201 of the structure 200 into the second portion 220. The slots may additionally extend further into the third portion of the structure 200.

Each of the energy harvesting systems 50 described herein may comprise a housing (not shown) provided around the transducer 100 and structure 200. The housing inhibits horizontal deflection of the structure during deformation under an applied force. Advantageously, this means that the structure 200 exerts a maximum force on the transducer for the greatest energy transfer. The housing may be in the form of a tubular element, pipe, or conduit, in which the transducer 100 and structure 200 are provided therein so that outer extent thereof abuts an internal wall of the housing. In this way, horizontal deflection of the structure is inhibited, ensuring force is focused toward the transducer.

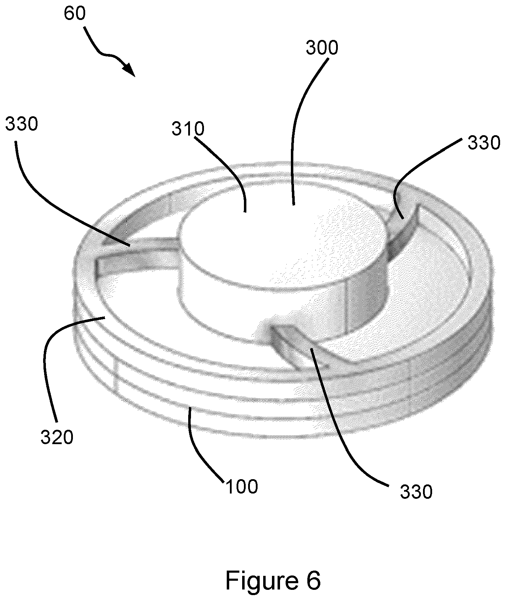

In a further embodiment, an energy harvesting system 60 is provided as shown in Figure 6. The system 60 comprises a structure 300 and a transducer 100.

As previously described, the transducer 100 is arranged to provide an output signal in response to deformation of the transducer 100 by an applied force to harvest energy from the applied force.

The structure 300 is in mechanical communication with the transducer 100. Deformation of the structure 300 is arranged to cause deformation of the structure. The structure 300 has a first portion 310. The structure 300 has a second portion 320 which, in the system 60, is in mechanical communication with the transducer 100. The structure has one or more third portions 330 which connect the first portion 310 and the second portion 320. The one or more third portions 330 comprise one or more curved arms.

Referring to Figure 6, the first portion 310 is centrally located in the structure 300. The first portion 310 provides a contacting surface to receive an applied force from a body. In examples, the first portion 310 may not be centrally located in the structure 300.

The structure 300 comprises a second portion 320. The second portion is in mechanical communication with the transducer 100. The second portion 320 is provided around the first portion 310. The second portion 320 provides the outer peripheral outline of the structure 300. The second portion 320 is a ring. In embodiments, the second portion 320 may be portions of a ring that are arranged radially around the first portion 310.

The first portion 310 is a rotatable member. The first portion 310 may be a shaft or a hub that can receive an applied force. The first portion 310 is rotatable relative to the second portion 320. In use, an applied force on the first portion effects rotation of the first portion 310 with respect to the second portion 320. Advantageously, this increases energy transfer to the transducer.

The structure comprises one or more third portions 330. The one or more third portions 330 comprise one or more curved arms. The one or more third portions connect the first portion 310 to the second portion 320. When the first portion 310 is a rotatable member, the one or more third portions 330 comprising curved arms transfer the force on the first portion 310 to the thirds portion 330. Advantageously, the one or more third portions 330 transfer the applied force from the first portion 310 to the second portion 320. In turn, the second portion 320 applies the force to the transducer 100 to harvest energy. Advantageously, the one or more third portions allow for improved deformation of the structure 300 such that deformation of the transducer 100 is improved.

The one or more third portions 300 extend radially from the first portion 310 to the second portion 320. The one or more third portions 330 may be provided as curved arms. That is, the third portions 330 are separate elongate curved arms that extend between the first portion 310 and the second portion 330. Advantageously, the curvature of the arms of the one or more third portions 330 allow the structure 300 to act as a spring. This improves the transfer of force from the structure 300 to the transducer 100.

As shown in Figure 6, three third portions 330 are provided. In embodiments, more or less than three third portions 330 may be provided. For example, four or more, five or more, six or more portions may be provided. The third portions 330 may be symmetrically provided in the structure 300.

The third portions 330 are curved arms that have equal revolutions. That is, the curved arms may be correspondingly, or equally, arcuate. Advantageously, this improves the distribution of force across the structure 300.

The curved arms of the third portions 330 shown in Figure 6 have 0.1 revolutions. In embodiments, the one or more curved arms each have between about 0.05 revolutions and 2 revolutions, preferably between about 1 revolution and 2 revolutions, most preferably 2 revolutions. In embodiments, the curved arm of each third portion 330 may have different revolutions.

In examples, the number of revolutions may vary based on whether a force is applied to the structure 300. The number of revolutions may vary based on rotational velocity, mass and energy available in the system 60. In examples, the number of revolutions may be greater than, or less than, 2.

The thickness of each of the curved arms of the third portion 330 is constant. In embodiments, the thickness of the third portions 330 varies. For example, the thickness of the third portions 330 may taper, i.e. reduce in the direction form the first portion 310 to the second portion 330. Advantageously, this may improve energy transfer while not compromising the structural strength of the structure 300. A varying thickness of the third portions 330 may also mean that the structure 300 is more flexible. In turn, the structure 300 may have greater deformation.

The gradient of the surface of the one or more third portions 330 may also vary. In embodiments, the gradient of the third portions 310 reduces in the direction from the first portion 310 to the second portion 320. The direction from the first portion 310 to the second portion 320 may be an arcuate directional line along, or following, the curved arm. Advantageously, this may improve the energy transfer from the applied force to the transducer.

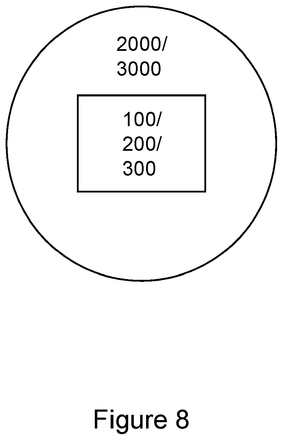

The third portions 330 of the structure may be provided in various arrangements. This is shown in plan view in Figures 8a to 8d. Each of the structures shown in each of these figures have first portions 310, second portions 320 and one or more third portions 330 as described with respect to Figure 6.

Each of the third portions 310 is a curved arm and has a different number of revolutions and pitch. The number of revolutions relates to the distance of the circumference of the structure that each third portion 330 extends around. The pitch relates to the distance between adjacent third portions 22. The thickness of each curved arm of the third portions is shown as 1mm. Advantageously, decreasing the thickness of the arm may provide for arm increase in energy produced. However, the thickness may be more or less than 1 mm. The thickness may be less than 1mm, for example 0.5mm or 0.1mm. In embodiments, the thickness may be greater than 1mm.

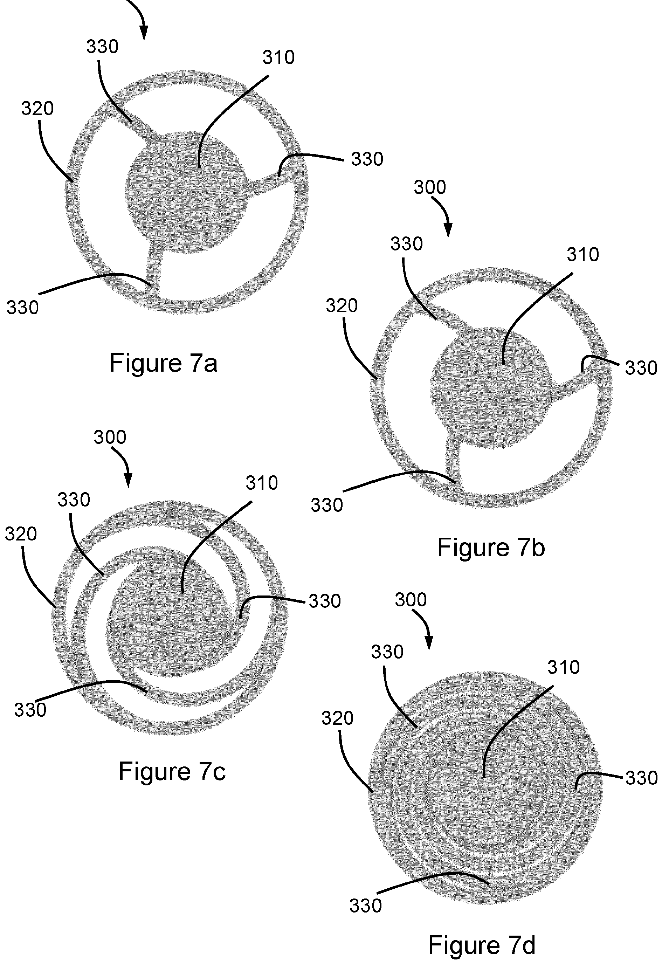

Figure 7a shows a structure 300 with the arms of the third portion 330 having 0.05 revolutions and a 180mm pitch.

Figure 7b shows the structure 300 of Figure 6 in plan view. The structure 300 has 0.1 revolutions and 90mm pitch.

Figure 7c shows a structure with the arms of the third portion having 1 revolution and 9mm pitch. This means that each curved arm of the third portion 330 curves around the circumference of the structure 300 exactly once.

Figure 7d shows a structure with the arms of the third portion 330 having 2 revolutions and 4.5mm pitch. Advantageously, adding revolutions and decreasing the pitch may increase tension in the third portion 330 and so increase energy stored by the structure.

While Figures 7a-7d show exemplary embodiments for arrangements of the third portion 330 of a structure 300, other arrangements are envisaged. For example, more or less revolutions that those shown may be provided. There may be provided less than 0.05 revolutions, any number or revolutions between 0.05 and 2 revolutions, or more than 2 revolutions. The pitch may vary as appropriate to the size of the structure and the number of revolutions provided. For example, a pitch may be less than 180mm, any length between 180mm and 4.5mm, or more than 4.5mm.

In use, the central first portion 310 rotates, or is rotated by a connected or mounted component or body, and exerts radial force on the third portion 330, which in turn provides force to the transducer 100. Advantageously, the arrangement of the third portions 330 of the structure and the rotatable first portion 310 mean that both compressive and rotational forces are applied. In effect, the structure 300 acts as a spring that oscillates around the central first portion 310 to act as a spring-mass system. As a result, more energy from the applied force may be stored in the structure 300 and in turn, amplified and transferred to the transducer 100. In response to this, the transducer deforms.

Figure 8 schematically depicts a projectile 2000 or munition 3000 comprising the system 50, 60 including the transducer 100 and the structure 200, 300 as described herein. A projectile may mean any object that moves freely under the influence of gravity and air resistance - e.g., it does not comprise any propulsion arrangement. Munitions are provided in different forms for different applications. Typically, a particular munition will be used for a particular application or intention. Munitions include, but are not limited to, artillery shells and charges, missiles, rockets and mortar rounds, as well as small arms munitions (e.g., bullets). Munitions typically include a charge, and optionally a fuze system for managing the detonation or explosion of that charge. Advantageously, the system 100 and structure 200, unlike batteries, can be stored for a long time without their performance being affected. Further advantageously, the system 100 and structure can be accommodated in the constrained space typically available in projectiles and munitions due to their small size. The system 100 and the structure 200 are cheap to manufacture.

The output signal may be used for powering an external component, for example for providing a source of electrical power to the fuze system, or providing a signal to the charge. Instead or additionally, the output signal may be used for detecting a change in state in the energy harvesting system. Consequently, the energy harvesting system may be used for power generation or as a sensor. Power generation may be more efficient. Similarly, the sensor may be more sensitive.

In summary, the invention provides an energy harvesting system that facilitates efficient energy harvesting and which is flexible, stable and robust enough to be used in projectiles and munitions. In these particular applications, the energy harvesting may be advantageously used to be a power supply or the sole power supply. Launch of a projectile and munition causes the transducer 100 to generate power sufficient to perform a function, for example powering or arming a fuze system, without a separate power supply. Alternatively or additionally, launch of a projectile and munition may actually be detected using the same transducer 100. As described above, the embodiments might allow for greater and more efficient power generation. The embodiments may also provide for more effective detection, by conversion of compressive forces by the modified structure due to its optimised shape.

## Claims

1. An energy harvesting system, comprising:
a transducer arranged to provide an output signal in response to deformation of the transducer by an applied force to harvest energy from the applied force;
a structure in mechanical communication with the transducer, deformation of the structure being arranged to cause deformation of the transducer,
wherein the structure comprises:
a first portion;
a second portion in mechanical communication with the transducer;
one or more third portions connecting the first portion and second portion, wherein the one or more third portions comprise one or more curved arms.

2. The system according to claim 1, wherein the first portion is centrally located in the structure, and the second portion is provided around the first portion.

3. The system according to claim 2, wherein the first portion is a rotatable member, optionally a shaft or hub.

4. The system according to any one of the preceding claims, wherein the first portion is rotatable relative to the second portion.

5. The system according to any one of the preceding claims, wherein the structure comprises three curved arms.

6. The system according to any one of the preceding claims, wherein the one or more third portions are symmetrically provided in the structure.

7. The system according to any one of the preceding claims, wherein the one or more third portions comprise at least a region of varying thickness.

8. The system according to claim 7 wherein the one or more third portions comprise at least a region of tapering thickness.

9. The system according to any one of the preceding claims, wherein a gradient of the surface of the one or more third portions reduces in a direction from the first portion to the second portion.

10. The system according to any one of the preceding claims, wherein the transducer is piezoelectric or magnetostrictive.

11. The system according to any one of the preceding claims, comprising a housing provided around the transducer and structure, the housing configured to inhibit horizontal deflection of the structure during deformation of the structure.

12. The system according to any one of the preceding claims, wherein the output signal is used for powering an external component and/or detecting a change in state in the energy harvesting system.

13. A structure for use in an energy harvesting system, the energy harvesting system comprising a transducer arranged to provide an output signal in response to deformation of the transducer by an applied force to harvest energy from the applied force, the structure being in mechanical communication with the transducer, deformation of the structure being arranged to cause deformation of the transducer, wherein the structure comprises:
a first portion;
a second portion in mechanical communication with the transducer; one or more third portions connecting the first portion and second portion, wherein the one or more third portions comprise one or more curved arms.

14. A projectile comprising the system or structure according to any one of the preceding claims.

15. A munition comprising the system or structure according to any one of the preceding claims.
